Europäisches Patentamt

European Patent Office

Office européen des brevets

(19)

(11) Veröffentlichungsnummer: **0 514 738 A2**

# (12) EUROPÄISCHE PATENTANMELDUNG

(21) Anmeldenummer: **92107947.1**

(22) Anmeldetag: **12.05.92**

(51) Int. Cl.⁵: **G01R 15/02**

(30) Priorität: **24.05.91 CH 1542/91**

(43) Veröffentlichungstag der Anmeldung:
**25.11.92 Patentblatt 92/48**

(84) Benannte Vertragsstaaten:
**AT DE FR GB IT**

(71) Anmelder: **Reichle + De-Massari AG**
**Elektro-Ingenieure**
**Binzstrasse 31**
**CH-8620 Wetzikon(CH)**

(72) Erfinder: **Reichle, Hans**
**Guldislooweg 16**
**CH-8620 Wetzikon(DE)**

(74) Vertreter: **Petschner, Goetz**
**Patentanwaltsbüro G. Petschner**
**Wannenstrasse 16**
**CH-8800 Thalwil(CH)**

(54) **Multifunktionales Prüf- und Messgerät für Starkstrom-Installationen.**

(57) Das multifunktionale Prüf- und Messgerät für Starkstrom-Installationen umfasst ein Gerätegehäuse (11) geeigneter, handlicher Form. In diesem Gerätegehäuse (11) ist ein, das Gerät steuernder Prozessor (12) mit Tastmitteln (14) zum Anwählen und Starten von Prüf- oder Messfunktionen angeordnet, dem ein Messumformer (13) nachgeschaltet ist mit einer Eingangsstufe (15) und einer, dem Prozessor (12), dem Messumformer (13) und der Eingangsstufe (15) gemeinsamen Speisestufe (16).

Wird eine der Funktionen, wie Fehlerstrom-Test, Drehrichtung, Isolationstest, Schleifenwiderstand, Cosinus Phi, Spannung, Spitzenstrom u. a. angewählt, erscheint im Display des Prozessors das betreffende Anschluss-Schaltbild, welches dem Benutzer genaue Anweisungen erteilt, wie er am Gerät anzuschliessen hat.

EP 0 514 738 A2

Fig.1

Die vorliegende Erfindung betrifft ein multifunktionales Prüf- und Messgerät für Starkstrom-Installationen.

Mess- und Prüfgeräte der vorgenannten Art sind in der Regel in einem gemeinsamen Gehäuse eingebaute Einzel-Mess- und Prüfeinheiten üblicher Bauart zur Strom- und Spannungsprüfung, zur Durchgangsprüfung oder Phasenprüfung u.a.,was dem Benutzer ausser der Kompaktheit keine weiteren Bedienungsvorteile bringt.

Aufgabe der vorliegenden Erfindung ist deshalb die Schaffung eines multifunktionalen Prüf- und Messgerätes für Starkstrom-Installationen, welches dem Benutzer einen hohen Bedienungskomfort gewährt bei optimaler Betriebssicherheit.

Dies wird erfindungsgemäss erreicht durch einen im Gerätegehäuse integrierten, das Gerät steuernden Prozessor mit Tastmitteln zum Auswählen und Starten von Prüf- oder Messfunktionen eines nachgeschalteten Messumformers mit einer Eingangsstufe und einer, dem Prozessor, dem Messumformer und der Eingangsstufe gemeinsamen Speisestufe.

In einer weiteren Ausgestaltung kann dann der Messumformer mindestens eine Schaltungsstufe für das Prüfen der Drehrichtung, eine Schaltungsstufe für die Durchführung eines FehlerstromTestes, eine Schaltungsstufe für die Durchführung eines Isolationstestes, eine Schaltungsstufe für das Prüfen des Schleifenwiderstandes, eine Schaltungsstufe für das Prüfen des Cosinus Phi, eine Schaltungsstufe für das Messen der Spannung, eine Schaltungsstufe für das Messen des Spitzenstroms und eine Schaltungsstufe für die Durchführung einer Durchgangsprüfung aufweisen.

Vorteilhaft ist es dann, wenn der Messumformer eine weitere Schaltungsstufe für das Aufladen des AKKU der Speisestufe sowie eine weitere Schaltungsstufe für die Funktion des Gerätes als Phasenprüfer aufweist.

Eine weitere erfindungswesentliche Ausgestaltung ist dann dadurch gegeben, dass mit der angewählten Prüf- oder Messfunktion im Display des Prozessors das betreffende Anschluss- Schaltbild erscheint.

Zudem ist es von Vorteil, wenn die Messresultate oder Fehlermeldungen im Display des Prozessors anzeigbar sind und gegebenenfalls dem Prozessor ein Drucker zuschaltbar ist.

Weitere Vorteile ergeben sich aus der nachfolgend beschriebenen beispielsweisen Ausführungsform und der Zeichnung. Es zeigen:

Fig. 1    in einem Blockschaltbild das multifunktionale Prüf- und Messgerät für Starkstrom-Installation und

Fig. 2 bis 9    Display-Anzeigen des Gerätes von betreffenden Anschluss-Schaltbildern der gewählten Prüf- oder Messfunktionen.

Das multifunktionale Prüf- und Messgerät für Starkstrom-Installationen umfasst ein hier nicht näher dargestelltes Gerätegehäuse 11 geeigneter, handlicher Form. In diesem Gerätegehäuse 11 ist ein, das Gerät steuernder Prozessor 12 mit Tastmitteln 14 zum Anwählen und Starten von Prüf- oder Messfunktionen angeordnet, dem ein Messumformer 13 nachgeschaltet ist mit einer Eingangsstufe 15 und einer, dem Prozessor 12, dem Messumformer 13 und der Eingangsstufe 15 gemeinsamen Speisestufe 16.

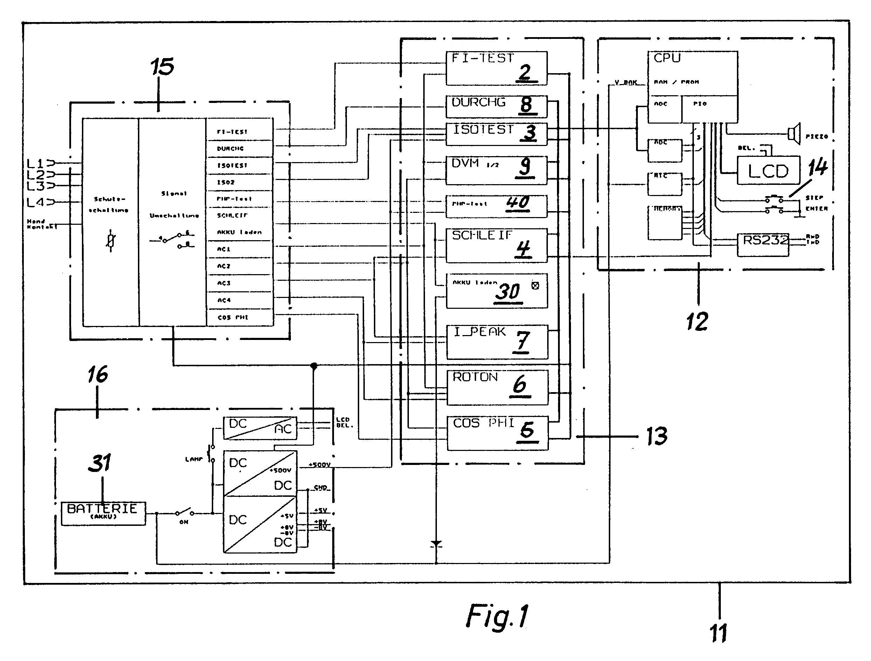

Der Messumformer 13 umfasst gemäss Fig. 1 eine Schaltungsstufe 6 für das Prüfen der Drehrichtung, eine Schaltungsstufe 2 für die Durchführung eines Fehlerstrom-Testes, eine Schaltungsstufe 3 für die Durchführung eines Isolationstestes, eine Schaltungsstufe 4 für das Prüfen des Schleifenwiderstandes, eine Schaltungsstufe 5 für das Prüfen des Cosinus Phi, eine Schaltungsstufe 9 für das Messen der Spannung, eine Schaltungsstufe 7 für das Messen des Spitzenstroms und eine Schaltungsstufe 8 für die Durchführung einer Durchgangsprüfung, wie das nachfolgend noch näher erläutert ist. Zudem weisst der Messumformer 13 eine weitere Schaltungsstufe 30 für das Aufladen des AKKU 31 der Speisestufe 16 sowie eine Schaltungsstufe 40 für die Funktion des Gerätes als Phasenprüfer auf, wie das ebenfalls nachfolgend noch näher erläutert ist.

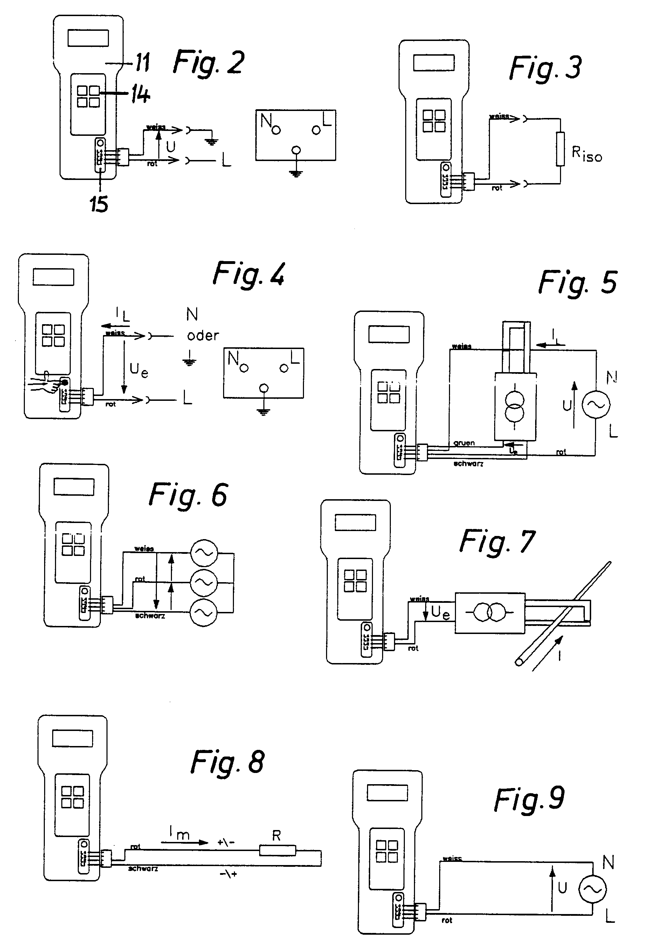

Wird eine dieser Funktionen angewählt, erscheint vorzugsweise im Display des Prozessors 12 das betreffende Anschluss-Schaltbild gemäss den Fig. 2 bis 9, welches dem Benutzer genaue Anweisung erteilt, wie das Gerät anzuschliessen ist.

Im Einzelnen zeigt Fig. 2, dass für einen Fehlstrom-Test ein Polleiter und ein Erdleiter eines zu prüfenden Stromkreises je an einen der Messanschlüsse der Eingangsstufe 15 des Gerätes anzuschliessen ist. Die betreffende Schaltungsstufe 2 des Messumformers 13 kann dann so sein, dass die Aufschaltung auf einen Brückengleichrichter erfolgt. Im Ausgangskreis des Gleichrichters können dann 6 unterschiedlich grosse Lastwiderstände parallelgeschaltet sein. Jeder dieser Lastwiderstände kann weiter über je einen Thyristor unabhängig eingeschaltet werden. Damit lässt sich dann der gewünschte Teststrom einstellen. Die Thyristoransteuerung erfolgt über Optokoppler direkt vom Prozessor 12. Die benötigte Zündspannung wird mit einer Zenerdioden-Spannungsstabilisierungund einem Kondensator direkt aus der am Gleichrichter anliegenden Spannung gewonnen. Im Display erscheint dann zweckmässig zuerst die Bereichswahl und anschliessend die eigentliche Testfunktion.

Da eine solche Schaltungsstufe wie auch die anderen erwähnten Schaltungstufen ansich bekannt sind, werden diese hier nicht näher veranschaulicht.

Zur Messung des Isolationswiderstandes gemäss Fig. 3 wird mit einem Schaltnetzteil aus der Batteriespannung eine Hochspannung erzeugt, die über die Signalumschaltung auf zwei Messanschlüsse der Eingangsstufe 15 gelangt. Durch Anschluss eines Prüflinges wird dann der Laststromkreis geschlossen. Ueber einem 3-stufig umschaltbaren, zum Prüfling in Serie geschalteten Messwiderstand wird der Laststrom, resp. die Spannung über dem Messwiderstand über einen Messverstärker dem im Prozessor eingebauten Analog/Digital-Wandler zugeführt (nicht gezeigt). Ebenfalls mit einem Wandler wird die Spannung des Netzteiles erfasst. Aus diesen beiden Werten rechnet der Prozessor den Wert des Isolationswiderstandes, dessen Wert im Display erscheint.

Die Messung des Schleifenwiderstandes gemäss Fig. 4 beruht auf zwei Strom- und Spannungsmessungen zur Bestimmung des Innenwiderstandes einer Spannungsquelle. Dabei wird eine Strom-/Spannungsmessung bei unbelasteter sowie bei belasteter Quelle vorgenommen. Dazu wird ein Polleiter und der Nulleiter oder Erdleiter über die Eingangsstufe 15 auf eine Serieschaltung, bestehend aus einem Triac als Lastschalter und einem Lastwiderstand geschaltet, welche die betreffende Schaltungsstufe 4 des Messumformers 13 bilden (nicht dargestellt). Die Messung der anliegenden Spannung kann mit dem internen Voltmeter 9 erfolgen. Der Laststrom wird über einem Messwiderstand erfasst. Die dort abfallende Spannung wird über Verstärkermittel auf einen Wandler des Prozessors geführt. Um dabei die relativ kleinen Spannungsdifferenzen zwischen erster und zweiter Spannungsmessung besser erfassen zu können, ist der Voltmeterschaltung ein Verstärker nachgeschaltet. Damit wird die erste Spannungsmessung analog gespeichert. Dieser Wert ergibt den relativen Nullpunkt für den nachgeschalteten Differenzverstärker. Somit wird die Differenzspannung zwischen erster und zweiter Messung direkt im externen Analog/Digital-Wandler umgesetzt (nicht gezeigt). Der Wandler ist dabei über eine serielle Schnittstelle mit dem Prozessor verbunden. Die Steuerung der Speicherschaltung erfolgt vom Prozessor. Aus den beiden Messwerten wird dann der Schleifenwiderstand berechnet und, mit dem Kurzschluss-Strom, im Display angezeigt.

Zur Messung des Leistungsfaktors Cosinus Phi werden gemäss Fig. 5 mit dem internen Voltmeter 9 an den Messanschlüssen der Eingangsstufe 15 die Spannung und der Strom, resp. die Spannung des Stromwandlers angeschlossen. Mit je einer, einem Spannungsresp. Strom-Gleichrichter/Vorverstärker nachgeschalteten zusätzlichen Verstärkerstufe mit hoher Verstärkung der betreffenden Schaltungsstufe 5 des Messumformers 13 wird aus dem anliegenden Sinussignal eine Rechteckform erzeugt. Diese beiden Rechtecksignale sind auf den Prozessor geschaltet, wo die Periodendauer des Spannungssignals und die zeitliche Verschiebung von Strom- zu Spannungssignal gemessen wird. Aus der Periodendauer wird die Frequenz und aus der Verschiebung Strom-/Spannungssignal der Cos.Phi berechnet und im Display angezeigt.

Zur Bestimmung der Drehrichtung eines Drehstromnetzes können gemäss Fig. 6 die mit der Eingangsstufe 15 verbundenen Polleiter über eine Umschaltung und hochomige Vorwiderstände der Schaltungsstufe 6 des Messumformers 13 auf einen Drehstrom-Brückengleichrichter und parallel dazu über je ein Spannungsanpassungsnetzwerk auf drei Komperatoren werden, welche der Signalformung dienen. Ueber einen zusätzlichen Komperator, der dem Gleichrichter nachgeschaltet ist, wird die Vergleichsspannung der drei Signalformungskomparatoren umgeschaltet. Diese ist abhängig von der vom Gleichrichter abgegebenen Ausgangsspannung. Die drei Rechtecksignale werden dann auf den Prozessor geführt und dort auf Phasenfolge geprüft und im Display vor dem Start und während der Messung angezeigt.

Zur Messung eines Spitzenstroms wird gemäss Fig. 7 die von einem Stromwandler gelieferte Spannung über einen Differenzverstärker der Schaltungsstufe 7 des Messumformers 13 auf einen aktiven Gleichrichter/Verstärker geschaltet, welches Signal dann wieder über einen Analog-/Digital-Wandler in den Prozessor 12 gelangt. Ist die Funktion gestartet, misst der Prozessor kontinuierlich das Eingangssignal. Mit einem Maximalspeicher wird das grösste Eingangssignal festgehalten und im Display angezeigt.

Für die Durchgangsprüfung wird gemäss Fig.8 die Batteriespannung über Kurzschlussstrom-Begrenzungswiderstände und eine Feinsicherung auf die Messanschlüsse geschaltet. Wird dann ein Prüfling angeschaltet, wird die anliegende Spannung, entkoppelt mit einem Spannungsfolger der Schaltungsstufe 8 des Messumformers 13, direkt dem Analog-/Digital-Wandler im Prozessor zugeführt. Der Strom durch den Prüfling wird über einem Begrenzungswiderstand mit einem Differenzverstärker gemessen und über den externen Analog-/Digital-Wandler dem Prozessor zugeführt. Aus dieser Strom-/Spannungs-Messung wird dann der Widerstand berechnet und im Display angezeigt.

Die Voltmeter-Messverstärker-Schaltungsstufe 9 des Messumformers 13 ist zweimal identisch vorhanden. Somit können Spannungen zwischen jeweils zwei Messanschlüssen der Eingangsstufe 15 gleichzeitig gemessen werden. Der genannte Messverstärker ist hier ein aktiver 2-Weg-Gleichrichter mit umschaltbarer Verstärkung. Nach dem Gleichrichter-Verstärker gelangt das Messsignal über den Analog-/Digital-Wandler in den Prozessor 12. Die Funktion der Bereichsumschaltung unterscheidet sich dabei nur durch je zwei separate Steuerleitungen vom Prozessor zu den Umschaltern für die entsprechenden Verstärker. Mit dem Prozessor wird die Bereichsumschaltung automatisch gesteuert. Wird dabei die Funktion Voltmeter angewählt, kann die an den Messanschlüssen anliegende Spannung kontinuierlich im Display abgelesen werden. Der zweite Voltmeterverstärker hingegen kann in der Funktion des Fehlerstrom-Testes (Fig.2) zur Anzeige der Eingangsspannung benutzt werden.

Zum Laden des AKKU 31 der Speisestufe 16 kann als Quelle für den AKKU-Ladestrom ein Spannungsregler-IC eingebaut sein, der aus 220V-Wechselspannung direkt 7V-Gleichspannung erzeugt. Mit dieser Gleichspannungsquelle wird der AKKU mit einem Ladestrom versorgt. Die Zuführung der Wechselspannung erfolgt über den bei der Schleifenwiderstandsmessung eingesetzten Lastwiderstand von den Messanschlüssen.

Ferner kann eine serielle Schnittstelle vorgesehen sein, die direkt vom Prozessor zur Verfügung gestellt wird. mit einem nachgeschalteten Treiberbaustein erfolgt dann die Umsetzung der Spannungspegel auf die verlangten Werte. Ueber einen Steueranschluss wird dieser Treiberbaustein vom Prozessorabgeschaltet, wenn die Schnittstelle inaktiv ist.

Die weitere Funktion als Phasenprüfer kann mit einer Glimmlampe und einem LDR als Schaltungsstufe 40 des Messumformers 13 realisiert werden. Wird dabei die Glimmlampe über einen in Serie geschalteten Vorwiderstand zum glimmen gebracht, verändert sich der Widerstand des damit beleuchteten lichtempfindlichen Widerstands. Dieser LDR ist in einem Spannungsteiler geschaltet. Die Ausgangsspannung dieses Teilers wird von einem Komparator ausgewertet und dem Prozessor als digitaler Wert zugeführt und im Display angezeigt.

Aus dem Vorbeschriebenen ergibt sich somit ein multifunktionales Prüf- und Messgerät für Starkstrom-Installationen, welches alle zu stellenden Bedingungen an Universalität, Einfachheit in der Bedienung und Sicherheit zu erfüllen vermag.

Selbstverständlich sind hierbei im Rahmen der Erfindung eine Reihe von Modifikationen und Erweiterungen denkbar. So kann der Prozessor eine LCD-Beleuchtung sowie einen Uhrenbaustein umfassen. Weiter können zusätzliche Mess- und Prüffunktionen vorgesehen sein.

**Patentansprüche**

1. Multifunktionales Prüf- und Messgerät für Starkstrom-Installationen,
gekennzeichnet durch
einen im Gerätegehäuse (11) integrierten, das Gerät steuernden Prozessor (12) mit Tastmitteln (14) zum Auswählen und Starten von Prüf- oder Messfunktionen eines nachgeschalteten Messumformers (13) mit einer Eingangsstufe (15) und einer, dem Prozessor (12), dem Messumformer (13) und der Eingangsstufe (15) gemeinsamen Speisestufe (16).

2. Gerät nach Anspruch 1,
dadurch gekennzeichnet, dass
der Messumformer (13) mindestens eine Schaltungsstufe ( 6 ) für das Prüfen der Drehrichtung, eine Schaltungsstufe (2) für die Durchführung eines Fehlerstrom-Testes, eine Schaltungsstufe (3) für die Durchführung eines Isolationstestes, eine Schaltungsstufe (4) für das Prüfen des Schleifenwiderstandes, eine Schaltungsstufe (5) für das Prüfen des Cosinus Phi, eine Schaltungsstufe (9) für das Messen der Spannung, eine Schaltungsstufe (7) für das Messen des Spitzenstroms und eine Schaltungsstufe (8) für die Durchführung einer Durchgangsprüfung aufweist.

3. Gerät nach Anspruch 2,
dadurch gekennzeichnet, dass
der Messumformer (13) eine weitere Schaltungsstufe (30) für das Aufladen des AKKU (31) der Speisestufe (16) sowie eine weitere Schaltungsstufe (40) für die Funktion des Gerätes als Phasenprüfer aufweist.

4. Gerät nach Anspruch 2 oder 3,
dadurch gekennzeichnet, dass
mit der angewählten Prüf- oder Messfunktion im Display des Prozessors (12) das betreffende Anschluss-Schaltbild (2 oder 3 oder .... 9) erscheint.

5. Gerät nach einem der vorangehenden Ansprüche 1 bis 4,
dadurch gekennzeichnet, dass
die Messresultate oder die Fehlermeldungen im Display des Prozessors (12) anzeigbar sind.

6. Gerät nach einem der Ansprüche 1 bis 5,
dadurch gekennzeichnet, dass
dem Prozessor (12) ein Drucker zuschaltbar ist.

*Fig.1*

FI-TEST **2**
DURCHG **8**
ISOTEST **3**
DVM 1/2 **9**
FHP-Test **40**
SCHLEIF **4**
AKKU laden **30**
I_PEAK **7**
ROTON **6**
COS PHI **5**

CPU
RAM / PROM
ADC
ADC
RTC
MEMORY
PIO
V_BAK

PIEZO
LCD
BEL.
STEP
ENTER
RS232

**14**
**12**
**13**
**11**

FI-TEST
DURCHG
ISOTEST
ISO2
FHP-Test
SCHLEIF
AKKU laden
AC1
AC2
AC3
AC4
COS PHI

Signal
Umschaltung

Schaltschaltung

L1
L2
L3
L4
Hand Kontakt

**15**
**16**
**31**

LCD BEL.
+500V
GND
+5V
-8V

DC
AC
DC
+500V
DC
DC
+5V
-8V
DC

LAMP
ON

BATTERIE (AKKU)

Fig. 2

11
14
15

N o   o L

weiss
U
rot
L

Fig. 3

weiss
$R_{iso}$
rot

Fig. 4

$I_L$
weiss
N
oder

$U_e$

rot
L

N o   o L

Fig. 5

weiss
$I$

$U$
N

gruen
schwarz
rot
L

Fig. 6

weiss
rot
schwarz

Fig. 7

weiss
$U_e$

rot
$I$

Fig. 8

$I_m$
+\−
R
rot
schwarz
−\+

Fig. 9

weiss
N
$U$
rot
L

7